# EUROPEAN PATENT APPLICATION

(11) **EP 1 231 643 A2**
(43) Date of publication of application: **14.08.2002**
(21) Application number: 02002549.0
(22) Date of filing: 04.02.2002
(51) Int. Cl.: H01L 29/10, H01L 29/778, H01L 29/165, H01L 21/335

(54) **MOS field-effect transistor comprising Si and SiGe layers or Si and SiGeC layers as channel regions**

(30) Priority: 09.02.2001 JP 2001034263
(71) Applicant: President of Tohoku University, Sendai 980-8577 (JP)
(72) Inventor: Murota, Junichi, Sendai-shi, Miyagi-ken (JP); Sakuraba, Masao, Wakabayashi-ku, Sendai-shi, Miyagi-ken (JP); Matsuura, Takashi, Sendai-shi, Miyagi-ken (JP); Tsuchiya, Toshiaki, Matsue-shi, Shimane-ken (JP)
(74) Representative: Hertz, Oliver, Dr.

(57) **Abstract**

The MOS field-effect transistor aims to enhance the electron mobility and the hole mobility in the channel portion by employing the strained-Si/SiGe (or Si/SiGeC) structure. Crystallinity of such a heterostructure is maintained in a preferable state, shortening of the effective channel length is prevented, diffusion of Ge is prevented and the resistance of the source layer and the drain layer is reduced. The channel region has a layered structure formed by stacking the Si layer (2) and, the SiGe or SiGeC layer (3) in order from the surface. The source layer (4) and the drain layer (5) formed of SiGe or SiGeC including high concentration impurity atoms providing a desired conduction type formed by the low-temperature CVD, are in contact with both end surfaces of the channel region. The surfaces of the source layer and the drain layer have a shape rising upwardly from the bottom portion of the gate electrode (6).

## Description

The present invention relates to a structure of a semiconductor device which can be effectively used for a MOSFET. More specifically, the present invention relates to a semiconductor device comprising an nMOSFET and/or pMOSFET having a layered region composed of Si layer/SiGe layer (or Si layer/SiGeC layer) as a channel region.

A MOSFET which takes advantage of an effect that electron mobility and hole mobility are enhanced in a strained-Si layer of a strained-Si/SiGe structure for acceleration of the MOSFET and which comprises the strained-Si/SiGe structure on a Si substrate as a channel region has been known (for example, Semicond. Sci. Technol. Vol.13, pp.1225-1246, 1998 C K Maiti et al. "Strained-Si heterostructure field effect transistors"). In addition, specific structures of an nMOSFET (for example, 1994 IEDM Tech. Dig., pp.373-376) and a pMOSFET (for example, 1995 IEDM Tech. Dig., pp.517-520) have been proposed.

In the strained-Si/SiGe or strained-Si/SiGeC structure, strain is formed in the Si layer since there is a difference in lattice constant between Si and SiGe or between Si and SiGeC. An energy band structure of the Si layer is varied due to the strain and, therefore, the electron mobility or hole mobility in the Si layer can be enhanced.

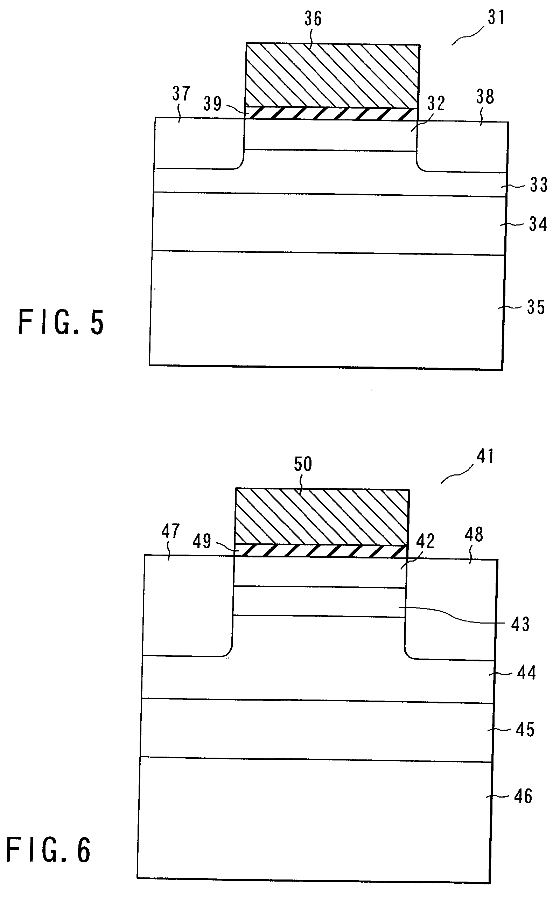

As shown in FIG. 5, for example, in a case of an nMOSFET 31, a structure formed by arranging a strained-Si layer 32, a non-strained-SiGe layer 33 and a SiGe graded-buffer layer 34 in order from the surface, on an Si substrate 35, to form a channel region has been known. In addition, as shown in FIG. 6, for example, in a case of a pMOSFET 41, a structure formed by arranging a strained-Si layer 42, a strained-SiGe layer 43, a non-strained-SiGe layer 44 and a SiGe graded-buffer layer 45 in order from the surface, on an Si substrate 46, to form a channel region has been known. In both cases, source regions 37 and 47, drain regions 38 and 48, gate oxide films 39 and 49, and gate electrodes 36 and 50 are formed for operations of the MOSFETs.

In a manufacturing process of the MOSFETs 31 and 41 in the prior art, however, predetermined impurity ion implantation and the following heat treatment are generally executed in a step of forming the source regions 37 and 47, and the drain regions 38 and 48 after forming the strained-Si/SiGe layer or the strained-Si/SiGeC layer. In such a heat treatment, the high-temperature heat treatment step needs to be executed to allow ion-implanted atoms to thermally move in substrate crystals. In a certain example, the high-temperature heat treatment is executed at 625°C for 2.5 minutes and then at 850°C for 10 seconds (for example, IEEE Electron Device Letters, vol.15, no.3, pp.100-102).

In a case where Ge is highly concentrated at a ratio of 0.3 or higher in the SiGe layers 33 and 43, if such a high-temperature heat treatment is executed, diffusion of Ge from the SiGe layers 33 and 43 to the Si layers 32 and 42 cannot be prevented. As a result, a problem arises that the Si/SiGe (or Si/SiGeC) surface becomes rough and thereby a high-quality heterostructure can hardly be obtained.

Further, there is another problem that by the high-temperature heat treatment, n-type or p-type impurity atoms in the source and drain layers diffuse in the channel region such that an effective channel length is shortened. If the effective channel length is thus shortened, a short circuit occurs between the source and the drain, particularly, in a device of an extremely small gate length.

When such a structure is applied to the MOSFET device of an extremely small gate length, a high impurity concentration region (a punch-through stopper region) is generally formed to restrain a short-channel effect of the MOSFET and to prevent the punch-through between the source and the drain. In this case, the punch-through stopper region is formed, for example, in the steps of the predetermined impurity ion implantation and the following heat treatment, after formation of the channel region of the strained-Si/SiGe layer or the strained-Si/SiGeC layer. In this case, too, there is the problem that Ge atoms diffuse from the SiGe layers 33 and 43 by the high-temperature heat treatment.

Moreover, generally, the depth of the source and drain layers is inclined to become small in accordance with miniaturization of the semiconductor device. For this reason, in the extremely fine device, the increase in the resistance values of the source and drain layers causes deterioration of the performance of the MOSFET device. Thus, there is another problem that a step of allowing additional highly impurity-doped Si layer for reducing the resistance to grow up, for example, on the source and drain layers, needs to be further added to form the structure capable of reducing the resistance values of the source and drain.

The present invention has been accomplished in consideration of the various problems in the prior art. Thus, the present invention aims to enhance the electron mobility and the hole mobility of the channel portion and keep crystallinity of the heterostructure in a preferable state, by employing the strained-Si/SiGe structure (or strained-Si/SiGeC structure). In addition, the present invention also aims to obtain a semiconductor device miniaturized and capable of high-speed operations by preventing shortening of the effective channel length, preventing undesired diffusion of Ge atoms to the strained-Si layer and further lowering the resistance of the source layer and the drain layer.

To solve the above technical problems and implement an LSI with ultrahigh speed and lower power consumption, in a MOS field-effect transistor of the present invention, the channel region can be formed with a multilayer structure including a layered structure formed by stacking the Si layer and the SiGe layer (or the Si layer and the SiGeC layer) in order from a lower surface of the gate, and the source and drain regions of SiGe (or SiGeC) including a high concentration impurity of, for example, 10²⁰cm⁻³ or more formed by the low-temperature CVD at a temperature of 550°C or lower, can be formed on both end surfaces of the channel region. Moreover, in the transistor of the present invention, top surfaces of the SiGe (or SiGeC) source/drain layers can be formed to have a shape rising upwardly from the bottom position of the gate electrode.

Further, in the MOS field-effect transistor of the present invention, a region including the impurity of the same conduction type as the conduction type of the Si substrate, at a higher concentration than the impurity in the Si substrate, can be formed inside or on the Si substrate immediately under the Si and SiGe (or Si and SiGeC) channel regions, to restrict the short channel effect.

That is, the MOS field-effect transistor of the present invention is a MOS field-effect transistor allowing the gate electrode to control the electric conduction of the channel region formed through the insulation film. The channel region has a layered structure formed by stacking the Si layer and the SiGe or SiGeC layer in order from the surface. The source layer and the drain layer, which are formed of SiGe or SiGeC including high concentration impurity atoms providing a desired conduction type formed by the vapor deposition, are respectively in contact with both ends of the channel region. Top surfaces of the source layer and the drain layer are positioned above the bottom portion of the gate electrode.

Further, the transistor of the present invention can be formed as what is called a bulk silicon type MOS field-effect transistor in which the channel region, source layer and the drain layer are formed above the Si substrate. Otherwise, the transistor can be formed as what is called a SOI (Silicon On Insulator) type MOS field-effect transistor in which the channel region, source layer and the drain layer are formed above the insulating substrate or the insulation layer.

Further, a MOS field-effect transistor wherein the bottom portions of the source layer and the drain layer are positioned at the same level as or below the bottom portion of the channel region and a region including impurity of the same conduction type as a conduction type of the Si substrate at higher concentration than impurity in the Si substrate is formed immediately under the channel region, can be formed. In addition, a MOS field-effect transistor wherein the region including the impurity of the same conduction type as the conduction type of the Si substrate at higher concentration than the impurity in the Si substrate is an atomic layer doping layer, can be formed.
In addition, a MOS field-effect transistor according to any one of claims 1 to 5, characterized in that the source layer and the drain layer are formed by low-temperature CVD at a temperature of 550°C or lower, can be formed.

In the present invention, as the source layer and the drain layer are formed by the low-temperature CVD, diffusion of Ge atoms and other impurities in the previously formed channel region is restricted. For this reason, deterioration of the Si/SiGe (or Si/SiGeC) heterostructure can be restricted and a short circuit between the source and the drain can be prevented.

As the source layer and the drain layer have a rising shape, the resistance in the source and the drain can be reduced. For this reason, a step of reducing the resistance of the source layer and the drain layer, for example, an ion implantation step, an impurity diffusion step or the like does not need to be added at the formation of the source layer and the drain layer. Moreover, a punch-through between the source and the drain can be restricted by, for example, providing a high concentration impurity region by the atomic layer doping, immediately under the channel region.

This summary of the invention does not necessarily describe all necessary features so that the invention may also be a sub-combination of these described features.

The invention can be more fully understood from the following detailed description when taken in conjunction with the accompanying drawings, in which:
FIG. 1 shows a first embodiment of the present invention;
FIGS. 2A to 2I show a manufacturing process of the first embodiment of the present invention;
FIG. 3 shows a second embodiment of the present invention;
FIG. 4 shows a third embodiment of the present invention;
FIG. 5 shows a structure of an nMOSFET of the prior art; and
FIG. 6 shows a structure of a pMOSFET of the prior art.

An embodiment of the present invention will be described below with reference to the drawings. The following explanations relate to the embodiments of the present invention to describe the general principle of the present invention. Accordingly, the present invention is not limited to the embodiments or the structures specifically shown in the attached drawings.

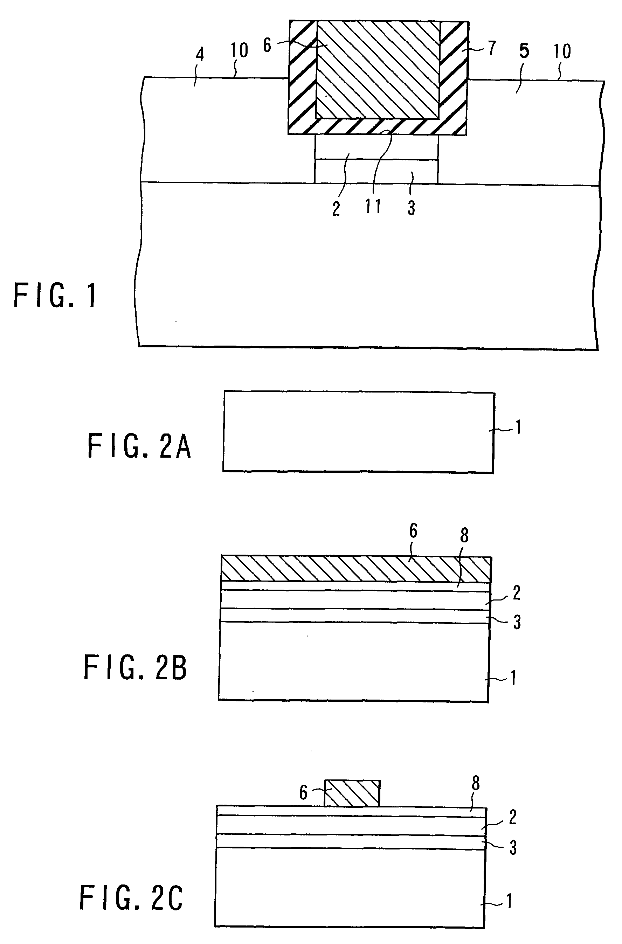

FIG. 1 shows a first embodiment of the present invention. A channel region is formed on a Si substrate 1. This channel region has at least a layered structure of a Si layer 2 and a SiGe layer (or SiGeC layer) 3. A p-type substrate is used for the Si substrate 1 when an nMOSFET is formed, and a n-type substrate is used when a pMOSFET is formed.

The Si layer 2 and the SiGe layer (or SiGeC layer) 3 are formed by, for example, the selective vapor deposition. The molecular beam epitaxy, deposition, and the like can be employed if necessary. The thickness of the SiGe layer (or SiGeC layer) 3 is 10 nm or smaller. The SiGe layer can be formed with a multilayer structure composed of, for example, a strained-SiGe layer and a SiGe graded buffer layer. The thickness of the Si layer 2 is about 5 nm. The Si layer 2 and the SiGe layer (or SiGeC layer) 3 can be formed as undoped layers which do not particularly include impurities. To adjust a threshold value of the MOS FIELD-EFFECT TRANSISTOR, however, the p-type or n-type impurity can be included during or after the formation of the layers.

A source layer 4 and a drain layer 5, which are formed of SiGe (or SiGeC), are in contact with both ends of the channel region. To reduce the resistance of the source layer 4 and a drain layer 5, the source layer 4 and a drain layer 5 should preferably include the n-type or p-type impurity which is highly concentrated, i.e. 10²⁰cm⁻³ or more as determined in response to the conduction type of the channel. To restrict the diffusion of Ge from the SiGe layer (or SiGeC layer) in the channel region and the surface roughness, the chemical vapor deposition should preferably be executed under the condition of 550°C or lower. Further preferably, low-temperature CVD should be executed at a temperature of 500°C or lower.

Generally, the source and drain layers of SiGe (or SiGeC) are formed by what is called selective epitaxial growth. As the source and drain layers are formed to be thick enough to reduce the resistance, a top end 10 is positioned above a gate electrode bottom portion 11 and has a shape rising from the substrate 1.

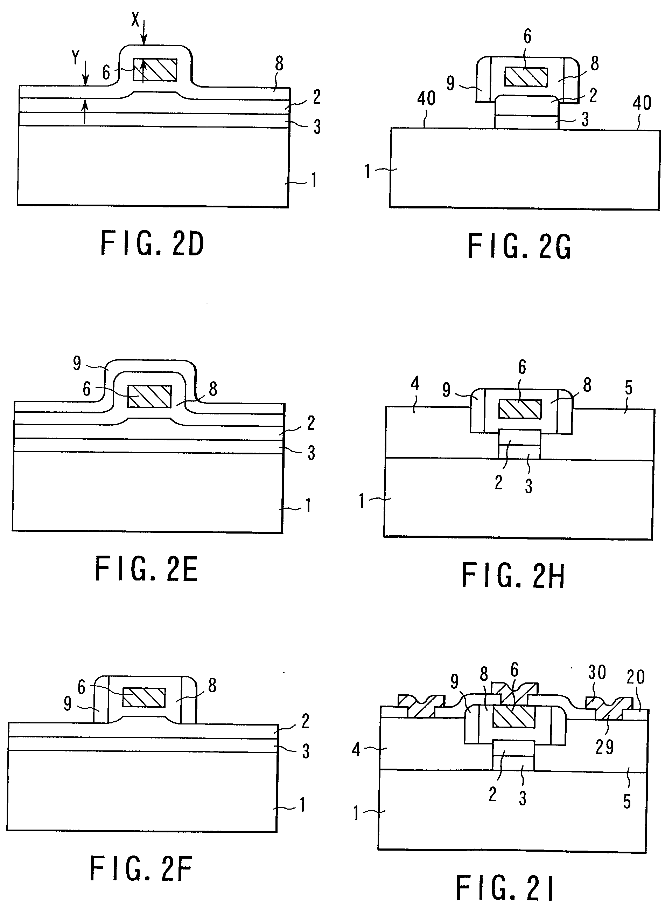

An insulation layer 7 functioning as a gate insulation film similarly to a general MOS field-effect transistor, is formed on the surface of the Si layer 2. The insulation layer 7 is of, for example, silicon dioxide, and the region which is in contact with the Si layer 2 functioning as a gate insulation film is formed by oxidizing the surface of the Si layer 2 in the general MOSFET manufacturing process. A gate electrode 6 is of polysilicon and is formed in the same manufacturing process as a polysilicon gate electrode of a general MOSFET. The insulation layer 7 is formed on a sidewall of the gate electrode 6, and the source layer 4 and the drain layer 5 are formed via the insulation layer 7. Polysilicon, SiGe and SiGeC are used as the gate electrode material in the present embodiment, but refractory metal materials such as Ti, Co, and the like can be used. A passivation insulation film 20 (see FIG. 2) is formed on the surfaces of the gate electrode 6, source layer 4 and drain layer 5 in a proper method and an electrode 30 is taken out therefrom through a predetermined through-hole 29.

FIGS. 2A to 2I show a manufacturing process of the first embodiment of the present invention. The monocrystalline silicon substrate 1 is prepared, and the SiGe layer (or SiGeC layer) 3, the Si layer 2, the SiO₂ layer 8, and a polysilicon layer which is to be the gate electrode 6, are sequentially formed on the surface of the monocrystalline silicon substrate 1. The SiGe layer is formed by the vapor deposition based on, for example, decomposition of SiH₄ and GeH₄ using H₂, Ar or N₂ gas as a carrier gas. The SiGeC layer is formed by the vapor deposition based on decomposition using SiH₃CH₃ together with SiH₄ and GeH₄. The SiO₂ layer 8 can be formed by, for example, thermally oxidizing the surface of the Si layer 2 similarly to a general MOSFET. The polysilicon layer is formed in a general method such as reduced-pressure CVD using SiH₄ gas or the like. To reduce the resistance of the polysilicon layer, high concentration n-type or p-type impurity such as As, P, B or the like is doped to the polysilicon layer by a general semiconductor process during or after the growth. Next, the polysilicon layer is patterned by the lithography to form the gate electrode 6.

Next, thermal oxidation is executed to form the SiO₂ film on the top surface and side surface of the gate electrode 6. In this step, a part of the surface of the Si layer 2 is also oxidized. However, as the oxidation rate of the polysilicon layer is high, thickness X of the SiO₂ film on the top surface of the gate electrode 6 is greater than thickness Y of the SiO₂ film on the top surface of the Si layer 2 (FIG. 2D).

Next, a silicon nitride layer 9 is formed on an entire surface of the substrate by, for example, vapor reaction of SiH₄ and NH₃.

Next, for example, what is called ECR (electron cyclotron resonance) plasma etching is executed to expose a Si surface of the Si layer 2. As the ECR plasma etching is anisotropic etching with a high longitudinal etching rate, the insulation layers 8, 9 on the sidewall of the gate electrode can be left sufficiently. In addition, as the SiO₂ film on the top surface of the gate electrode 6 is thicker than the SiO₂ film on the top surface of Si layer 2, the top surface of the gate electrode can be left such that the top surface of the gate electrode can be coated.

Next, the Si layer 2 and the SiGe layer (or SiGeC layer) 3 at the portion exposed at the above step are etched by, for example, a general etching such as dry etching or the like, to leave the only gate region portion. A Si substrate surface 40 in the source and drain regions is exposed by the etching.

Next, the SiGe layer (or SiGeC layer) is subjected to the selective vapor deposition on the exposed surface 40 to form source and drain layers including a high concentration impurity. To prevent diffusion of the impurity to the SiGe layer (or SiGeC layer) in the channel region, the low-temperature CVD is executed. The vapor deposition is executed by decomposition of, for example, SiH₄ and GeH₄ (or, for example, SiH₄, GeH₄ and SiH₃CH₃), using H₂, Ar or N₂ gas as a carrier gas. To prevent undesired deposition of SiGe or SiGeC on the SiO₂ film and the like, HCl gas can be added to the carrier gas if necessary.

Next, the passivation film 20 including, for example, a Si oxide, a Si nitride and the like is formed on the entire surface of the substrate including the gate electrode 6, the source layer 4 and the drain layer 5, by a proper method. Further, the electrode 30 is formed through the predetermined through-hole 29 and a MOSFET device is thereby formed.

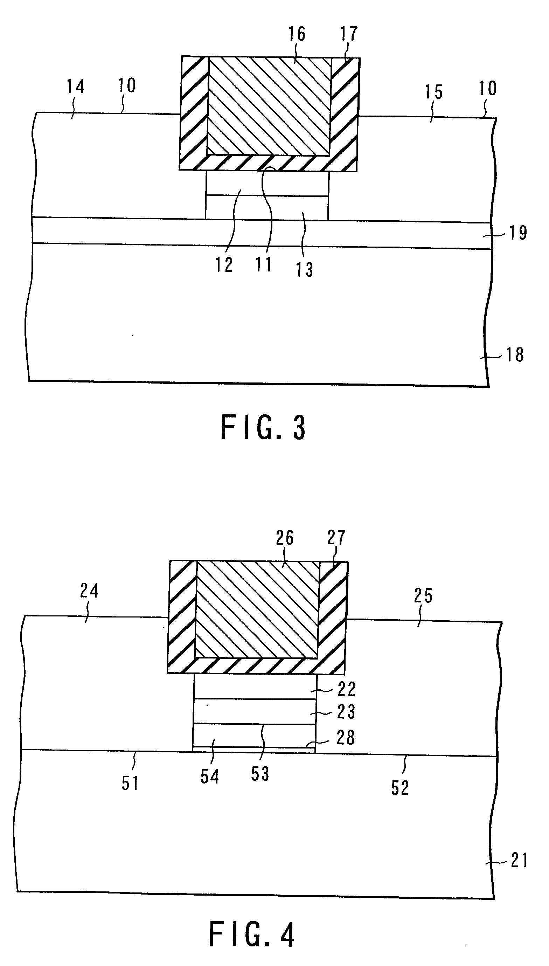

FIG. 3 shows a second embodiment of the present invention. Channel regions 12 and 13 are formed on a thin-film Si layer 19 on an insulation film 18 instead of the Si substrate of the first embodiment. In the channel regions, the Si layer 12 and the SiGe layer (or SiGeC layer) 13 are laminated from the surface. A source layer 14 and a drain layer 15, which are composed of a SiGe layer (or SiGeC layer) including a high concentration impurity of P-type or N-type formed by, for example, the low-temperature CVD executed at a temperature of 550°C or lower, are formed on both side surfaces of the channel regions. The top end 10 of the source layer 14 and the drain layer 15 composed of a SiGe layer (or SiGeC layer) is positioned above the bottom portion 11 of the gate electrode and has a swelling shape.

The structure in which the thin-film Si layer 19 is formed on the insulation film 18 can be formed by a method which is generally known as SOI (Silicon On Insulator). For example, a SIMOX (Separation by IMplanted OXgen) wafer formed by implanting oxygen ions highly concentrated at about 10¹⁸cm⁻² to a Si substrate and subjecting the Si substrate to high-temperature heat treatment at a temperature of 1300°C or higher, a wafer formed by what is called wafer bonding technique, which forms an oxide film on at least one of two Si substrates, bonds the two Si substrates via the oxide film and thins one of the Si substrates, or the like, can be used. By using such a wafer, insulation between the FET devices in an integrated circuit where a plurality of MOSFETs are formed in a chip can easily be executed.

FIG. 4 shows a third embodiment of the present invention. The difference to the first embodiment shown in FIG. 1 is to provide a region 28, i.e. an atomic layer doping layer 28, which is formed through a Si layer 54 by what is called atomic layer doping and which includes an impurity of the same conduction type as the Si substrate 21 at higher concentration than that in the Si substrate 21, immediately under the channel region composed of a Si layer 22 and a SiGe layer (or SiGeC layer) 23. This atomic layer doping layer 28 is formed by alternately depositing an impurity atom layer of, for example, P, B, or the like and a thin Si layer on the surface of the Si substrate 21. A high impurity concentration layer with concentration of 10²¹cm⁻³ or more can also be obtained by employing the atomic layer doping.

For this reason, bottom portions 51 and 52 of a source layer 24 and a drain layer 25, which are composed of a SiGe layer (or siGeC layer) is on the same level as or below a bottom portion 53 of the Si/SiGe (or siGeC) channel region.

The manufacturing process of the third embodiment is almost the same as the manufacturing process of the first embodiment shown in FIGS. 2A to 2I. The difference is that the atomic layer doping layer 28 and a Si layer 54 are formed on the entire surface of the substrate before the formation of the SiGe layer (or siGeC layer) 3 in FIG. 2B.

After the formation of the atomic layer doping layer 28 and the Si layer 54, the SiGe layer (or SiGeC layer) 23 and the Si layer 22 are sequentially formed on the Si layer 54. Then, a gate oxide film 27 and a gate electrode 26 are formed in the same manner as that of FIGS. 2A to 2I. After that, the Si layer 22 and the SiGe layer (or SiGeC layer) 23, and then the Si layer 54 and the atomic layer doping layer 28, formed on the surface of the source and drain regions, are removed for selective vapor deposition of the source layer 24 and the drain layer 25. Finally, the layer 28 including high concentration impurity atoms is provided by the atomic layer doping, immediately under the channel region composed of the Si layer 22 and the SiGe layer (or SiGeC layer) 23.

A high concentration impurity layer such as a high concentration diffusion layer, a high concentration ion implantation layer, a high concentration vapor deposition layer or the like, which is in the same conduction type as the Si substrate 21, can be formed under the gate region, instead of the atomic layer doping layer.

In the first to third embodiments, a case where a single MOSFET is provided on the substrate has been described. However, of course, a plurality of MOSFETs described above can be formed in a single chip when an integrated circuit is manufactured. In addition, nMOSFETs and pMOSFETs can be provided together in a single chip by implanting n-type impurity and p-type impurity separately to the source region, the drain region and the like.

Some embodiments according to the present invention have been described while shown in the drawings. However, the described embodiments of the present invention are simply examples thereof, and the present invention can be variously modified without exceeding the technical field of the present invention.

The present invention is not limited to the above-described embodiments, and can be variously modified in a range which does not exceed the gist of the present invention when it is carried out. Further, the above-described embodiments include various aspects of the invention, and various inventions can be extracted from arbitrary combination of a plurality of disclosed constituent elements.

As described above, according to the present invention, the source and drain regions are formed by the selective vapor deposition method based on the low-temperature CVD after formation of the Si/SiGe (or SiGeC) channel region and, therefore, undesired impurity diffusion to the SiGe layer (or SiGeC layer) is restricted as disclosed in the first embodiment of FIGS. 1, 2A to 2I and the second embodiment of FIG. 3. Deterioration of the Si/SiGe (or SiGeC) heterostructure is restricted by the restriction of diffusion of Ge, and a short circuit between the source and the drain is restricted by the restriction of diffusion of the impurity. In addition, the source and drain layers have a swelling structure and thereby parasitic resistance is reduced.

Moreover, by providing the high concentration impurity region by the atomic layer doping immediately under the channel region, the punch-through is reduced and high resistance to pressure between the source and the drain is implemented, as described in the third embodiment shown in FIG. 4.

## Claims

1. A MOS field-effect transistor allowing a gate electrode formed through an insulation film to control electric conduction of a channel region, **characterized in that**:
the channel region has a layered structure formed by stacking a Si layer, and a SiGe layer or SiGeC layer in order from a surface;
a source layer and a drain layer, which are formed of any of SiGe and SiGeC including high concentration impurity atoms providing a desired conduction type formed by vapor deposition, are respectively in contact with ends of the channel region; and
top surfaces of the source layer and the drain layer are positioned above a bottom portion of the gate electrode.

2. A MOS field-effect transistor according to claim 1, **characterized in that** the channel region, the source layer and the drain layer are formed at an upper part of a Si substrate.

3. A MOS field-effect transistor according to claim 1, **characterized in that** the channel region, the source layer and the drain layer are formed at an upper part of an insulation layer.

4. A MOS field-effect transistor according to claim 2, **characterized in that** bottom portions of the source layer and the drain layer are positioned at the same level as or below a bottom portion of the channel region and a region including impurity of the same conduction type as a conduction type of the Si substrate at higher concentration than impurity in the Si substrate is formed immediately under the channel region.

5. A MOS field-effect transistor according to claim 4, **characterized in that** the region including the impurity of the same conduction type as the conduction type of the Si substrate at higher concentration than the impurity in the Si substrate is an atomic layer doping layer.

6. A MOS field-effect transistor according to any one of claims 1 to 5, **characterized in that** the source layer and the drain layer are formed by low-temperature CVD at a temperature of 550°C or lower.
